(19) Europäisches Patentamt

European Patent Office

Office européen des brevets

(11) EP 0 297 785 B1

(12) **EUROPEAN PATENT SPECIFICATION**

(45) Date of publication and mention
of the grant of the patent:
**09.09.1998 Bulletin 1998/37**

(51) Int Cl.$^6$: **C30B 21/02**, C30B 29/52,
C22C 19/05

(21) Application number: **88305758.0**

(22) Date of filing: **24.06.1988**

(54) **Ni based superalloy for single crystal**

Superlegierung auf Nickelbasis für Einkristalle

Superalliage à base de Ni pour monocristal

(84) Designated Contracting States:
**AT BE CH DE ES FR GB GR IT LI LU NL SE**

(30) Priority: **29.06.1987 JP 159771/87**

(43) Date of publication of application:
**04.01.1989 Bulletin 1989/01**

(73) Proprietors:
• **Daido Tokushuko Kabushiki Kaisha
Nagoya-city Aichi-prefecture (JP)**
• **Morinaga, Masahiko
Toyohashi City Aichi Pref. (JP)**

(72) Inventors:
• **Yukawa, Natsuo
(JP)**
• **Morinaga, Masahiko
Toyohashi-city Aichi-prefecture (JP)**
• **Suzuki, Akihiro
Kagiya-cho Tokai-city Aichi-prefecture (JP)**

(74) Representative: **Jenkins, Peter David et al
PAGE WHITE & FARRER
54 Doughty Street
London WC1N 2LS (GB)**

(56) References cited:
FR-A- 2 371 516          GB-A- 2 106 138
GB-A- 2 184 456          US-A- 4 459 160

## Description

This invention relates to a Ni based superalloy for single crystal suitable for use in components and products requiring high strength, toughness and corrosion resistance at high temperatures.

Recently, in a power engine such as jet engine, gas turbine engine and the like, it is necessary and indispensable to raise the temperature at the turbine inlet in order to improve the performance and efficiency of the engine, so that the development of turbine blade materials possible to be proof against such a high temperature has become an important subject.

The main properties required for turbine blade materials are an excellent creep rupture strength and a toughness endurable in the centrifugal force at high temperatures, and an excellent corrosion resistance against an atmosphere of high temperature combustion gas. At present day, a single crystal material of Ni based superalloy is regarded as being hopeful to satisfy the required properties, and is in a stage of practical application in part.

The single crystal material of Ni based super alloy, unlike conventional cast alloy (equiaxed crystal) and unidirectional-solidificated columnar crystal alloy, is possible to be subjected to a solution treatment at a temperature just below its solidus because it has no grain boundaries, and an homogeneous structure from which solidificational segregation is excluded perfectly can be obtained. Therefore it has a feature that both of the creep rupture strength and the toughness are remarkably high as compared with those of conventional alloys. Also, the solution treatment at high temperature makes solution hardening elements possible to be added by large amounts into the alloy as compared with conventional alloys, so that the single crystal material of Ni based superalloy has a special merit that the creep rupture strength can be further increased by the addtion of a large amount of W or Ta acting effectively for solution hardening.

Lately, developments of single crystal alloys having excellent properties as described above are being promoted strongly, and many alloys have been invented.

Nevertheless, all of these alloys have been invented for the main purpose of improvement on the creep rupture strength at high temperatures, and it is true that the corrosion resistance at high temperatures which is the another property required has not been particularly investigated.

Namely, it is most effective to increase the Cr content for improving the corrosion resistance. However, as the Cr content increases, the solubility limit of the element with high solution hardening tendency such as W or Ta decreases, which is made impossible to increase the creep rupture strength. Thus the alloy of which the creep rupture strength is increased at the sacrifice of its corrosion resistance by decreasing the Cr content extremely has been developed, though the corrosion resistance at high temperature is not improved so sufficiently.

The present invention aims to overcome the real problems of the prior art referred to above.

The Ni based superalloy for a single crystal according to this invention is characterized by consisting of, 6 to 15 wt% of Cr, 5 to 12 wt% of W, 0.01 to 4 wt% of Re, 3 to 9 wt% of Ta, 0.5 to 2 wt% of Ti, 4 to 7 wt% of Al with the total amount of Ta, Ti and Al being 14 to 16% in atomic percentage ; and, optionally, 0.5~3.0 wt% of Mo with the total amount of W and Mo being not more than 4% in atomic percentage ; and the contents of C, B, Zr, O and N being limited to 0.01 wt% maximum, 0.005 wt% maximum, 0.01 wt% maximum, 0.005 wt% maximum and 0.005 wt% maximum respectively; and the balance being Ni and inevitable impurities.

Preferably, the Mdt value calculated using the following equation is 0.980 to 0.990, the equation being:-

$$\text{Mdt} = 1.142 \times (\text{atomic fraction of Cr}) + 1.655 \times (\text{atomic}$$

$$\text{fraction of W}) + 1.550 \times (\text{atomic fraction of Mo}) \text{ (only in}$$

$$\text{the case containing Mo}) + 1.267 \times (\text{atomic fraction of Re})$$

$$+ 2.224 \times (\text{atomic fraction of Ta}) + 2.271 \times (\text{atomic fraction}$$

$$\text{of Ti}) + 1.900 \times (\text{atomic fraction of Al}) + 0.717 \times (\text{atomic}$$

$$\text{fraction of Ni}).$$

The present invention will now be described in greater detail by way of example only.

The reason why limitations are made on the chemical compositon and other preferable conditions of the Ni based superalloy for single crystal according to this invention will be described below.

Cr : 6~15 wt%

Cr is an element effective to improve the corrosion resistance of alloys at high temperatures, such an effect appears remarkbly in the alloy with Cr content of 6 wt% or more. Although this effect becomes stronger with Cr content, the excess addition of Cr not only lowers the solubility limit but also deteriorates the high temperature strength by precipitating the TCP phase that is an embrittled phase, so that it is necessary to define the upper limit as 15 wt%.

W : 5~12 wt%

W is soluble in the $\gamma$- phase being matrix and in the $\gamma'$ -phase being preciptated phase, and it is an element acting effectively in enhanceing the creep strength by the solution hardening. In order to obtain such an effect sufficiently, the Cr content of not less than 5 wt% is necessary. However the addition of W increases the weight of alloy owing to its large density and degrades the corrosion resistance of alloy at high temperatures. Also, when the content exceeds 12 wt%, the needle-shaped $\alpha$ -W phase is precipitated and the creep strength and toughness are degraded, so that it is necessary to define the upper limit as 12 wt%.

Mo : 0.5~3.0wt%

Because Mo has the same effect as is shown in W, a part of W can be replaced by Mo if necessary. Mo enhances the creep strength by raising the solvus temperature of the $\gamma'$ -phase. In order to obtain such an effect sufficiently, the Mo content of not less than 0.5 wt% is required. And it is possible to make the alloy lighter since Mo has a small density as compared with W. Howerer, Mo degrades the corrosion resistance of alloy, so that it is necessary to define the upper limit as 3.0 wt% in the case of addition.

W + Mo : not more than 4 % in atomic percentage

Mo and W are soluble in the $\gamma$ -phase and show the same effect as mentioned above, however when the total amount of these elements exceed 4 atomic percent, the precipitation of $\alpha$ -W phase or $\alpha$ -W(Mo) phase in needle-shape degrades the creep strength and toughness. Therefore it is necessary to define the upper limit of total amount as 4 atomic percent.

Re : 0.01~ 4 wt%

Re is almost soluble in the $\gamma$ -phase matrix, and enhances the creep strength by solution hardening, and also an effective element for improving the corrosion resistance of alloy. In order to obtain such an effect sufficiently, the Re content not less than 0.01 wt% is required. However, Re is expensive and its addition increases the weight of alloy owing to the large density. Also, when the content exceeds 4 wt%, the needle-shaped $\alpha$ -W phase or $\alpha$ -W(Mo) phase is precipitated and the creep strength and toughness are degraded, so that it is necessary to define the upper limit as 4 wt%.

Ta : 3~ 9 wt%

Ta is soluble in the $\gamma'$ -phase in the form of [$Ni_3(Al,Ta)$] , and strengthens the phase by solution hardening. Therefore the creep strength is enhanced. In order to obtain such an effect sufficiently, the content of not less than 3 wt% is required, however when the content exceeds 9 wt%, the precipitation of $\delta$-phase [$Ni_3Ta$] in needle-shape owing to saturation degrades the creep strength. Consequently, it is necessary to define the upper limit as 9 wt%.

Ti : 0.5 ~2wt%

Ti is soluble in the $\gamma'$ -phase in the form of [$Ni_3(Al,Ta,Ti)$] and strengthens the phase by solution hardening likewise Ta, but not so effective as Ta. Ti has rather the effect of improving the corrosion resistance of alloys at high temperatures, and so the content is defined as not less than 0.5 wt%. However the addition more than 2 wt% rather degrades the corrosion resistance so that it is necessary to define the upper limit as 2 wt%.

Al : 4~7 wt%

Al is an element composing the $\gamma'$ -phase [$Ni_3Al$] that is a precipitation hardening phase, it is necessary to define the content in the range from 4 to 7 wt% in order to precipitate the $\gamma'$-phase of not less than 60 % by volume percentage in this alloy system.

Ta + Ti + Al : 14 ~16 atomic percent

From the relationship between the creep rupture strength of the Ni based superalloy at high temperature and the volume percentage of precipitated $\gamma'$-phase, it is known that the maximum strength is obtained at the volume percentage of the $\gamma'$-phase ranging from 60 to 65% in poly-crystal alloys. In order to obtain such an $\gamma'$-phase in alloy system according to this invention, it is necessary to limit the total amount of Ta, Ti and Al, which are $\gamma'$-phase forming elements, to the range from 14 to 16 atomic percent. Therefore the total amount of Ta, Ti and Al is defined as within 14~16 atomic percent.

C : not more than 0.01 wt%

B : not more than 0.005 wt%

Zr : not more than 0.01 wt%

These elements are used as grain- boundary strengthening elements in conventional cast alloys and unidirectional-solidificated columnar crystal alloys. However, such grain boundary strengthening elements are unnecessary in the single crystal, rather act as harmful elements for the following reasons, so that their addition is necessary to be restricted as follow.

C forms carbide (TiC, TaC etc.) and that is precipitated massively. Because the carbide, of which melting point is low as compared with that of alloy, causes local melting in the solution treatment at a temperature just below the solidus of alloy, it is not possible to elevate the solution treatment temperature and so the temperature range of solution treatment for the single crystal is restricted. Therefore, the upper limit of C content is defined as 0.01wt%.

B forms boride [$(Cr, Ni, Ti, Mo)_3B_2$] and that is precipitated at grain boundary. The boride, of which melting point is also low as compared with that of alloy likewise the carbide, reduces the solution treatment temperature for the single crystal, and restricts the temperature range of solution treatment. Therefore, the upper limit of B content is defined as 0.005 wt%.

Zr reduces the solidus temperature of alloy and extends the solidification temperature range ($\Delta T$), so its presence is harmful to single-crystalgrowth. Therefore, the upper limit of Zr content is defined as 0.01 wt%.

O : not more than 0.005 wt%

N : not more than 0.005 wt%

Both of these elements are mostly brougth with raw materials for the alloy. O is also brought from a crucible. These elements exist massively in the alloy as oxide ($Al_2O_3$) and nitride (TiN or AlN). If these compounds exist in the alloy for single crystal, the creep rupture time decreases, because such compounds act as initiation points of cracking during the creep deformation. Thus the upper limit of both O and N contents are defined as 0.005 wt%.

Mdt value : 0.980 ~ 0.990

In the developed alloy where the $\gamma'$-phase is precipitated in the range of about 60 65 % by volume percentage , the $\gamma / \gamma'$ eutectic phase is precipitated between the dendrite arms owing to solidificational segregation during the casting of single crystal. In the single crystal alloy, such a $\gamma / \gamma'$ eutectic phase is dissolved perfectly by the solution treatment at a temperature just below the solidus of the alloy, thereby the creep property at high temperature is improved. However, when the $\gamma / \gamma'$ eutectic phase is precipitated abundantly owing to the balance of chemical composition, the $\gamma / \gamma'$ eutectic phase is never dissolved and retained even after the soution treatment at a temperature just below the solidus, and so the creep strength is degraded. In this alloy system, the upper limit that precipitated $\gamma / \gamma'$ eutectic phase can be dissolved perfectly by solution treatment is expressed as 0.990 of Mdt value calculated from the following equation. On the contrary, if Mdt value becomes smaller, the creep strength and toughness are degraded, so that it is suitable to define the lower limit as 0.980.

$$Mdt = 1.142 \times (\text{atomic fraction of cr}) + 1.655 \times (\text{atomic}$$

$$\text{fraction of W}) + 1.550 \times (\text{atomic fraction of Mo}) (\text{only in}$$

the case containing Mo) + 1.267 × (atomic fraction of Re)

+ 2.224 × (atomic fraciton Of Ta) +2.271 × ( atomic

fraction of Ti) + 1.900 × (atomic fraction of Al) + 0.717 × (atomic fraction of Ni)

## Example

In Table 1, chemical compositions of example alloys according to this invention (No.1 ∼ 5) and comparative example alloys (No.6,7) are shown. In the table, the comparative alloy No.7 has already been put to practical use, and the comparative alloy No.6 is under investigation for practical applications.

Respective alloys were melted in a small-sized vacuum induction furnace using a refractory crucible with a capacity of 5 Kg, and shaped into an ingot of 60mm in diameter and 200mm in length.

Casting of a single crystal was carried out according to Bridgman-method by cutting the ingot to a rod of 12.5mm in diameter and 120mm in length, and growing in a recrystallized alumina crucible with a sharpened tip, which maintaining at 1550°C in an atmosphere of purified argon gas.

Casted single crystal specimen was subjected to a two-step aging treatment at 1050°C for 16hours and at 850 °C for 48hours and then air cooling after a solution treatment at 1320°C for 5hours.

Then a creep test specimen of 3.18mm thickness and 30mm length at a parallel portion, and a high temperature corrosion test specimen of 10mm length, 5mm width and 1mm thickess were cut out from heat-treated single crystals by machining.

A creep rupture test was carried out under the condition of testing temperature of 1050°C and applied stress of 14Kgf/mm$^2$.

Furthermore, a high temperature corrosion test was carried out holding the specimen coated with a mixed salt of $Na_2SO_4$-25%NaCl by an amount of 20mg/cm$^2$ in flowing air (50ml/min) at 900°C for 24hours, and then an increase in weight of the specimen (corrosion gain) was measured.

These results are also shown in Table 1.

Table 1

| No. | Chemical composition (wt%) | | | | | | | | | | | | | | Mdt value | Creep rupture time(hr) | Corrosion gain (mg/cm²) | Remarks |
|---|---|---|---|---|---|---|---|---|---|---|---|---|---|---|---|---|---|---|
| | Cr | W | Re | Ta | Ti | Aℓ | Mo | C | B | Zr | O | N | Others | Ni | | | | |
| 1 | 7.67 | 9.04 | 3.05 | 4.54 | 1.57 | 5.31 | — | 0.003 | 0.0005 | 0.005 | 0.0005 | 0.0009 | — | bal. | 0.984 | 856 | 8.0 | Example |
| 2 | 7.63 | 11.24 | 3.03 | 3.13 | 1.56 | 5.28 | — | 0.004 | 0.0006 | 0.006 | 0.0006 | 0.0008 | — | bal. | 0.984 | 775 | 0 | |
| 3 | 7.65 | 10.52 | 3.04 | 3.25 | 1.96 | 5.07 | — | 0.003 | 0.0005 | 0.004 | 0.0011 | 0.0010 | — | bal. | 0.984 | 893 | 3.2 | |
| 4 | 8.62 | 6.00 | 0.77 | 7.88 | 0.95 | 5.37 | 0.77 | 0.005 | 0.0005 | 0.005 | 0.0008 | 0.0012 | — | bal. | 0.984 | 936 | 5.3 | |
| 5 | 8.65 | 5.85 | 1.54 | 7.68 | 0.95 | 5.35 | 1.54 | 0.003 | 0.0005 | 0.005 | 0.0009 | 0.0009 | — | bal. | 0.984 | 1012 | 3.5 | |
| 6 | 8.93 | 10.61 | — | 3.35 | 1.14 | 5.51 | 1.01 | — | — | — | — | — | — | bal. | 0.980 | 992 | 16.6 | Comparative |
| 7 | 10.22 | 3.95 | — | 12.05 | 1.47 | 4.96 | — | — | — | — | — | — | Co:5.05 | bal. | 1.002 | 650 | 15.6 | Example |

As apparantly from the results shown in Table 1, it is evident that the corrosion gain is very small and the creep rupture time is excellent in all the cases of example alloys No.1~5 obtainded in this invention, and it has been certified that the invented alloys are remarkably improved in the corrosion resistance at high temperatures without sacrificing the high temperature creep rupture time.

On the contrary, comparative alloy No,6 being outside the range of chemical composition of the alloy according to this invention is inferior in the corrosion resistance at high temperature nevertheless it is satisfactory in the creep rupture time, and comparative alloy No.7 is inferior in both the creep rupture time and the corrosion resistance.

As mentioned above, the Ni based superalloy for single crystal according to this invention consists of, 6 to 15 wt% of Cr, 5 to 12 wt% of W, 0.01 to 4 wt% of Re, 3 to 9 wt% of Ta, 0.5 to 2 wt% of Ti, 4 to 7 wt% of Al with the total amount of Ta, Ti and Al being 14 to 16% in atomic percentage: and if necessary 0.5 to 3.0 wt% of Mo with the total amount of W and Mo being not more than 4% in atomic percentage; and the contents of C, B, Zr, O and N are limited to 0.01 wt% maximum, 0.005 wt% maximum, 0.01 wt% maximum, 0.005 wt% maximum and 0.005 wt% maximum respectively; and the balance being Ni and inevitable impurities; and the Mdt value calculated using a prescribed equation is 0.980 to 0.990 in the preferred aspect of this invention, so that it is possible to improve the corrosion resistance at high temperature without sacrificing the creep rupture strength at high temperature, and this invention brings a very excellent effect that the alloy is applicable to the case of elevating the temperature at the turbine inlet in order to improve the performance and efficiency of the engine such as jet engine, gas turbine engine and the like.

The preferred embodiments of the present invention can provide a Ni based superalloy for single crystal which is improved the corrosion resistance at high temperatures without sacrificing the creep rupture strength at high temperatures.

Although the letters Mdt do not have a meaning especially, the Mdt value has been found experimentally by the inventors to be a very convenient parameter for estimating whether or not a precipitated eutectic phase in the alloy can be dissolved by solution treatment, and for discriminating whether or not the creep strength and the toughness of the alloy are degraded from a viewpoint of the chemical composition of the alloy.

## Claims

1. A Ni based superalloy for a single crystal consisting of 6 to 15 wt % of Cr, 5 to 12 wt % of W, 0.01 to 4 wt% of Re, 3 to 9 wt% of Ta, 0.5 to 2 wt% of Ti, 4 to 7 wt% of Al with the total amount of Ta, Ti and Al being 14 to 16 % in atomic percentage; and the contents of C,B,Zr,O and N being limited to 0.01 wt% maximum, 0.005 wt% maximum, 0.01 wt% maximum, 0.005 wt% maximum and 0.005 wt % maximum respectively; and the balance being Ni and inevitable impurities.

2. A Ni based superalloy for single crystal according to claim 1, wherein the Mdt value calculated using the following equation is 0.980 to 0.990.

$$Mdt = 1.142 \times (\text{atomic fraction of Cr}) + 1.655 \times (\text{atomic fraction of W}) + 1.267 \times (\text{atomic fraction of Re}) + 2.224 (\text{atomic fraction of Ta}) + 2.271 \times (\text{atomic fraction of Ti}) + 1.900 \times (\text{atomic fraction of Al}) + 0.717 \times (\text{atomic fraction of Ni})$$

3. A Ni based superalloy for a single crystal consisting of 6 to 15 wt% of Cr ,5 to 12 wt% of W, 0.5 to 3.0 wt% Mo with the total amount of W and Mo being not more than 4% by atomic percentage; and 0.01 to 4 wt% of Re, 3 to 9 wt% of Ta, 0.5 to 2 wt% of Ti, 4 to 7 wt% of Al with the total amount of Ta, Ti and Al being 14 to 16% in atomic percentage ; and the contents of C, B, Zr, O and N being limited to 0.01 wt % maximum, 0.005 wt% maximum, 0.01 wt% maximum, 0.005 wt% maximum and 0.005 wt % maximum respectively ; and the balance being Ni and inevitable impurities.

4. A Ni based superalloy for single crystal according to claim 3, wherein the Mdt value calculated using the following equation is 0.980 to 0.990.

$$Mdt = 1.142 \text{ (atomic fraction of Cr)} + 1.655 \times \text{(atomic}$$

$$\text{fraction of W )} + 1.550 \times \text{(atomic fraction of Mo)} + 1.267 \times$$

$$\text{(atomic fraction of Re)} + 2.224 \times \text{(atomic fraction of Ta)}$$

$$+ 2.271 \times \text{(atomic fraction of Ti )} + 1.900 \times \text{(atomic}$$

$$\text{fraction of Al)} + 0.717 \times \text{(atomic fraction of Ni)}$$

## Patentansprüche

1. Superlegierung auf Nickelbasis für einen Einkristall, bestehend aus 6 bis 15 Gew.-% Cr, 5 bis 12 Gew.-% W, 0,01 bis 4 Gew.-% Re, 3 bis 9 Gew.-% Ta, 0,5 bis 2 Gew.-% Ti, 4 bis 7 Gew.-% Al, wobei die Gesamtmenge von Ta, Ti und Al 14 bis 16 Atom-% beträgt und die Gehalte an C, B, Zr, O und N jeweils auf 0,01 Gew.-% maximal, 0,005 Gew.-% maximal bzw. 0,005 Gew.-% maximal eingeschränkt sind und der Rest aus Ni und unvermeidlichen Verunreinigungen besteht.

2. Superlegierung auf Nickelbasis für einen Einkristall nach Anspruch 1, bei welcher der nach der folgenden Gleichung berechnete Mdt-Wert 0,980 bis 0,990 beträgt.

$$Mdt = 1,142 \text{ x (atomarer Anteil von Cr)} + 1,655 \text{ x (atomarer Anteil von W)} + 1,267 \text{ x (atomarer Anteil von Re)} +$$

$$2,224 \text{ x (atomarer Anteil von Ta)} + 2,271 \text{ x (atomarer}$$

$$\text{Anteil von Ti)} + 1,900 \text{ x (atomarer Anteil von Al)} + 0,717$$

$$\text{x (atomarer Anteil von Ni)}.$$

3. Superlegierung auf Nickelbasis für einen Einkristall, welche besteht aus 6 bis 15 Gew.-% Cr, 5 bis 12 Gew.-% W, 0,5 bis 3,0 Gew.-% Mo, wobei die Gesamtmenge an W und Mo nicht mehr als 4 Atom-% beträgt, sowie aus 0,01 bis 4 Gew.-% Re, 3 bis 9 Gew.-% Ta, 0,5 bis 2 Gew.-% Ti, 4 bis 7 Gew.-% Al, wobei die Gesamtmenge an Ta, Ti und Al 14 bis 16 Atom-% beträgt und die Gehalte an C, B, Zr, O und N jeweils auf 0,01 Gew.-% maximal, 0,005 Gew.-% maximal, 0,01 Gew.-% maximal, 0,005 Gew.-% maximal bzw. 0,005 Gew.-% maximal eingeschränkt sind und der Rest aus Ni und unvermeidlichen Verunreinigungen besteht.

4. Superlegierung auf Nickelbasis für einen Einkristall nach Anspruch 3, bei welcher der unter Verwendung der folgenden Gleichung berechnete Mdt-Wert 0,980 bis 0,990 beträgt.

$$Mdt = 1,142 \text{ x (atomarer Anteil von Cr)} + 1,655 \text{ x atomarer}$$

$$\text{Anteil von W)} + 1,550 \text{ x (atomarer Anteil von Mo)} + 1,267$$

$$\text{x (atomarer Anteil von Re)} + 2,224 \text{ x (atomarer Anteil von}$$

$$\text{Ta)} + 2,271 \text{ x (atomarer Anteil von Ti)} + 1,900 \text{ x (atomarer Anteil von Al)} + 0,717 \text{ x (atomarer Anteil von Ni)}.$$

## Revendications

1. Superalliage à base de Ni pour un monocristal, caractérisé par 6 à 18 % en poids de Cr, 5 à 12 % en poids de W, 0.01 à 4 % en poids de Re, 3 à 9 % en poids de Ta, 0.5 à 2 % en poids de Ti, 4 à 7 % en poids d'Al, la quantité totale de Ta, Ti et Al étant de 14 à 16 % en pourcentage atomique et les teneurs de C, B, Zr, O et N étant limitées à 0.01 % en poids maximum, 0.005 % en poids maximum, 0.01 % en poids maximum, 0.005 % en poids maximum et 0.005 % en poids maximum respectivement, et le complément étant Ni et les impuretés inévitables.

2. Superalliage à base de Ni pour un monocristal selon la revendication 1, caractérisé par la valeur Mdt de 0.980 à 0.990 calculée en utilisant l'équation suivante :

$$Mdt = 1.142 \text{ x (fraction atomique de Cr)}$$

$$+ 1.655 \text{ x (fraction atomique de W)}$$

$$+ 1.267 \text{ x (fraction atomique de Re)}$$

$$+ 2.224 \text{ x (fraction atomique de Ta)}$$

$$+ 2.271 \text{ x (fraction atomique de Ti)}$$

$$+ 1.900 \text{ x (fraction atomique de Al)}$$

$$+ 0.717 \text{ x (fraction atomique de Ni).}$$

3. Superalliage à base de Ni pour un monocristal, caractérisé par 6 à 15 % en poids de Cr, 5 à 12 % en poids de W, 0.5 à 3.0 % en poids de Mo, la quantité totale de W et Mo ne dépassant pas 4 % en pourcentage atomique, et 0.01 à 4 % en poids de Re, 3 à 9 % en poids de Ta, 0.5 à 2 % en poids de Ti, 4 à 7 % en poids de Al, la quantité totale de Ta, Ti et Al étant de 14 à 16 % en pourcentage atomique, et les teneurs en C, B, Zr, O et N étant limitées à 0.01 % en poids maximum, 0.005 % en poids maximum, 0.01 % en poids maximum, 0.005 % en poids maximum et 0.005 % en poids maximum respectivement, et le complément étant Ni et les inévitables impuretés.

4. Superalliage à base de Ni pour un monocristal selon la revendication 3, caractérisé par la valeur Mdt de 0.980 à 0.990, calculée en utilisant l'équation suivante :

$$Mdt = 1.142 \text{ x (fraction atomique de Cr)}$$

$$+ 1.655 \text{ x (fraction atomique de W)}$$

$$+ 1.550 \text{ x (fraction atomique de Mo)}$$

$$+ 1.267 \text{ x (fraction atomique de Re)}$$

$$+ 2.224 \text{ x (fraction atomique de Ta)}$$

$$+ 2.271 \text{ x (fraction atomique de Ti)}$$

$$+ 1.900 \text{ x (fraction atomique de Al)}$$

$$+ 0.717 \text{ x (fraction atomique de Ni).}$$